# EUROPEAN PATENT APPLICATION

(11) **EP 4 624 628 A1**
(43) Date of publication of application: **01.10.2025**
(21) Application number: 23894198.3
(22) Date of filing: 18.08.2023
(51) Int. Cl.: C23F 1/18, H05K 3/06

(54) **COPPER ETCHANT**

(30) Priority: 22.11.2022 JP 2022186779
(71) Applicant: MEC COMPANY., LTD., Amagasaki-shi, Hyogo 660-0822 (JP)
(72) Inventor: MAEDA Yukihiro, Amagasaki-shi, Hyogo 660-0822 (JP)
(74) Representative: dompatent von Kreisler Selting Werner - Partnerschaft von Patent- und Rechtsanwälten mbB
(86) International application number: PCT/JP2023/029875
(87) International publication number: WO 2024/111182

(57) **Abstract**

A problem is to provide a copper etchant capable of stably maintaining smoothness after etching.

As means for solving the problem, the etchant contains hydrogen peroxide, sulfuric acid, an aromatic compound, and a chlorine ion, in which the aromatic compound has a structure in which a hydroxyl group and/or a carboxy group is bonded to a benzene ring.

## Description

### Technical Field

The present invention relates to a copper etchant.

### Background Art

In a process of manufacturing a semiconductor or a printed wiring board, metal patterning or formation of a recess is performed by wet etching. For example, in a semiconductor manufacturing process, wet etching is used to form a groove or a recess. In addition, in a printed wiring board manufacturing process, a metal layer formed of copper or the like is patterned by wet etching to form a metal wiring.

In formation of a copper wiring by a semi-additive method, which is a type of wiring forming method, a copper layer called a "seed layer" is formed on an insulating substrate by electroless plating, a plating resist is formed on the seed layer, and then, pattern plating is performed on a resist opening formed on the seed layer by electrolytic copper plating. Thereafter, the plating resist is removed, and the seed layer remaining between the wirings is removed by wet etching to form a copper wiring. In the removal of the seed layer by the wet etching, not only the seed layer but also the copper wiring portion is etched by an etchant, and thus, the etching may affect the wiring shape or characteristics.

Examples of the etchant for removing such a seed layer include those described in Patent Documents 1 and 2.

Patent Document 1 describes an etchant containing sulfuric acid and hydrogen peroxide, and further containing a benzotriazole compound and an amine compound. Patent Document 1 describes that such an etchant can suppress undercut of a copper wiring at the time of removing a seed layer.

Patent Document 2 describes an etchant containing sulfuric acid and hydrogen peroxide, and further containing an amino acid, a nitrogen-containing heterocyclic compound such as azoles, halogen, and the like. Patent Document 2 describes that such an etchant can maintain a smooth surface shape of a copper wiring or the like even after removal of a seed layer.

However, in the etching using a so-called sulfuric acid hydrogen peroxide-based etchant described in Patent Documents 1 and 2, the smoothness of the copper surface after the etching is insufficient, and particularly, there is a problem that it is difficult to stably maintain the smoothness after the etching when an etching treatment is continuously performed.

### Documents for prior art

### Patent Documents

Patent Document 1: JP 2011-202242 A
Patent Document **2:** JP 2021-195572 A

### Summary of Invention

### Technical Problem

The present invention has been made in view of the above-described problems of the prior art, and an object thereof is to provide a copper etchant capable of stably maintaining smoothness of a copper surface after etching.

### Solution to Problem

The present invention includes hydrogen peroxide, sulfuric acid, an aromatic compound, and a chlorine ion, wherein the aromatic compound has a structure in which a hydroxyl group and/or a carboxy group is bonded to a benzene ring.

The chlorine ion may be contained in an amount of 0.000020 mass% or more and 0.02 mass% or less.

The aromatic compound may be one or more selected from the group consisting of phenols, a benzoic acid compound, 2-hydroxybenzoic acid, 5-sulfosalicylic acid, methyl salicylate, sodium salicylate, isoamyl salicylate, and acetylsalicylic acid.

Triazoles may be further contained.

The triazoles may be one or more selected from the group consisting of 1,2,4-triazole, 1,2,3-triazole, 3-amino-5-mercapto-1,2,4-triazole, 3,5-diamino-1,2,4-triazole, 3,5-dimethyl-1,2,4-triazole, 3-mercapto-1,2,4-triazole, 4-amino-1,2,4-triazole, 3-amino-1,2,4-triazole, 4-amino-3-mercapto-4H-1,2,4-triazole, and 3-amino-5-methylthio-1H-1,2,4-triazole.

### Effects of Invention

According to the present invention, it is possible to provide a copper etchant capable of stably maintaining smoothness of a copper surface after etching.

### Brief Description of Drawings

Fig. 1 is a chart showing a result of analyzing a surface of a test substrate by an EDS apparatus.
Fig. 2 is a chart showing a result of analyzing a surface of a test substrate by an EDS apparatus.
Fig. 3 is a graph showing a relationship between a change in chlorine ion concentration and an Sdr value.

### Description of Embodiments

Hereinafter, embodiments of a copper etchant (hereinafter, also simply referred to as an etchant) of the present invention will be described.

The copper etchant of the present embodiment is an etchant containing hydrogen peroxide, sulfuric acid, an aromatic compound, and a chlorine ion, in which the aromatic compound has a structure in which a hydroxyl group and/or a carboxy group is bonded to a benzene ring.

### [Copper]

The copper etched with the etchant of the present embodiment may be copper (pure copper) and a copper alloy containing copper. Hereinafter, in the present specification, "copper" refers to copper or a copper alloy.

### [Hydrogen peroxide]

The hydrogen peroxide acts as an oxidant for copper in the etchant.

A concentration of the hydrogen peroxide in the etchant is, for example, in a range of 4 mass% or more and 25 mass% or less, or 5 mass% or more and 20 mass% or less.

When the concentration of the hydrogen peroxide is in the above range, the hydrogen peroxide can appropriately function as an oxidant for copper.

### [Sulfuric acid]

The sulfuric acid acts as a component that dissolves copper oxidized in the etchant. In the etchant, copper is converted into copper oxide by hydrogen peroxide, and the copper oxide is dissolved in a solution by an acid to etch the copper.

A concentration of the sulfuric acid during etching is, for example, in a range of 5 mass% or more and 30 mass% or less, or 10 mass% or more and 20 mass% or less.

When the concentration of the sulfuric acid is in the above range, oxidized copper can be appropriately dissolved in the etchant.

### [Aromatic compound]

The aromatic compound is a compound having a structure in which a hydroxyl group and/or a carboxy group is bonded to a benzene ring.

In the aromatic compound of the present embodiment, it is preferable that at least one of the hydroxyl group and the carboxy group is directly bonded to a carbon atom constituting a benzene ring.

Examples of the aromatic compound having a structure in which a hydroxyl group is bonded to a benzene ring include phenols such as phenol, methylphenol, and dimethylphenol. Among them, a phenol having a structure in which only a hydroxyl group is bonded to a benzene ring is preferable.

Examples of the aromatic compound having a structure in which a carboxy group is bonded to a benzene ring include benzoic acid compounds such as benzoic acid, an adduct in which another functional group is added to benzoic acid such as nitrobenzoic acid or aminobenzoic acid, and a salt of benzoic acid such as sodium benzoate.

Examples of the aromatic compound having a structure in which a hydroxyl group and a carboxy group are bonded to a benzene ring include 2-hydroxybenzoic acid (salicylic acid), 5-sulfosalicylic acid, methyl salicylate, sodium salicylate, isoamyl salicylate, and acetylsalicylic acid.

When a compound having a structure in which both a hydroxyl group and a carboxy group are bonded to a benzene ring is used as an aromatic compound, there is an advantage that smoothness after etching can be maintained in a particularly preferred state.

A concentration of the aromatic compound in the etchant is, for example, in a range of 0.0001 mass% or more and 1 mass% or less, 0.0005 mass% or more and 0.5 mass% or less, or 0.0008 mass% or more and 0.1 mass% or less.

When the concentration of the aromatic compound is in the above range, smoothness after etching can be maintained in a more suitable state.

### [Chlorine ion]

The chlorine ion acts as a component that suppresses etching of copper.

The chlorine ion can be blended by containing a chlorine ion source in the etchant. Examples of the chlorine ion source include sodium chloride, calcium chloride, aluminum chloride, magnesium chloride, and ammonium chloride.

A chlorine ion concentration in the etchant is, for example, in a range of 0.00001 mass% or more and 0.5 mass% or less, 0.000015 mass% or more and 0.05 mass% or less, or 0.00002 mass% or more and 0.02 mass% or less.

When the chlorine ion concentration is in the above range, an etching rate of copper can be appropriately suppressed, and etching performance can be easily adjusted to a suitable range.

### [Triazoles]

The etchant of the present embodiment can further contain triazoles.

In the present embodiment, the triazoles refer to 1,2,3-triazole, 1,2,4-triazole, and a derivative in which each functional group is bonded to a triazole skeleton.

The triazole skeleton refers to a compound containing a 5-membered nitrogen-containing heterocyclic ring containing three nitrogen atoms.

Examples of the derivative include compounds in which an alkyl group such as an amino group, a mercapto group, a methyl group, or an ethyl group is bonded to a triazole skeleton.

Among them, a triazole derivative to which an amino group or a mercapto group is bonded is preferable.

More specific examples of the triazoles include 1,2,3-triazole, 1,2,4-triazole, 3-amino-5-mercapto-1,2,4-triazole, 3,5-diamino-1,2,4-triazole, 3,5-dimethyl-1,2,4-triazole, 3-mercapto-1,2,4-triazole, 4-amino-1,2,4-triazole, 3-amino-1,2,4-triazole, 4-amino-3-mercapto-4H-1,2,4-triazole, and 3-amino-5-methylthio-1H-1,2,4-triazole.

A concentration of the triazoles in the etchant is, for example, in a range of 0.00001 mass% or more and 1.0 mass% or less, 0.00005 mass% or more and 0.5 mass% or less, or 0.00009 mass% or more and 0.48 mass% or less.

When the concentration of the triazole is in the above range, smoothness after etching is more easily maintained in a suitable state. In addition, etching performance for electroless copper-plated copper is easily improved by containing triazole. Therefore, an etchant suitable for removing a seed layer by a semi-additive method without remaining in a portion other than a wiring is obtained.

### [Other components]

As the etchant of the present embodiment, other additives may be added as necessary. Examples of the other components include an additive for enhancing solubility of each component, an additive for suppressing decomposition of each component, a copper ion source as an oxidation promoting component of metal copper, a pH adjusting agent, and a surfactant.

For example, when a copper ion source, which is an oxidation promoting component of metal copper, is contained, examples of the copper ion source include copper sulfate and a copper salt of an organic acid.

When the copper ion source is contained, a content thereof is preferably about 1.4 mass% or more and 4.2 mass% or less.

Note that a pH of the etchant of the present embodiment is not particularly limited, and may be in a range of a pH of 3 or less, 2 or less, or the like.

### [Solvent]

The etchant can be easily prepared by dissolving each of the components described above in an appropriate solvent such as ion-exchanged water, pure water, or ultrapure water.

As the respective components of the etchant, those exemplified can be used alone or in combination of two or more thereof unless otherwise specified.

The etchant of the present embodiment can be prepared by mixing the respective components described above by a known method.

Note that, in consideration of solubility or decomposability, some of the components may be mixed first, and then, all the components may be mixed immediately before use. Alternatively, a concentrated solution in which a part of the solvent is mixed may be prepared, and the remaining solvent may be mixed immediately before use to prepare an etchant having an appropriate concentration.

A method for etching copper with the etchant of the present embodiment is not particularly limited, and the etchant can be used by a known method. Examples thereof include etching treatment methods by immersion, spraying, and the like. Treatment conditions such as a treatment temperature and a treatment time can also be appropriately adjusted.

For example, when etching is performed by spraying, a spray pressure is 0.05 to 0.20 MPa, a solution temperature is 20°C or higher and 35°C or lower, and the treatment time is 20 seconds or longer and 300 seconds or shorter.

In addition, when etching is performed by immersion, the solution temperature is 20°C or higher and 35°C or lower, and the treatment time is 20 seconds or longer and 300 seconds or shorter.

An index indicating smoothness of a copper surface etched with the etchant of the present embodiment can be evaluated by, for example, the following index.

A developed area ratio (Sdr) value of an interface measured based on ISO25178 is, for example, 0.20% or less, preferably 0.18% or less, and more preferably 0.175% or less.

The Sdr value is a value indicating how much the developed area (surface area) of the measurement surface is increased with respect to the area of the measurement surface, and the smaller the Sdr value is, the smoother the surface is. The value can be measured by, for example, a known shape analysis laser microscope. Details are measured by the method described in examples described below.

Furthermore, an arithmetic mean roughness (Ra) measured according to JIS B 0601 (2013) is, for example, 0.11 µm or less, 0.10 µm or less, or 0.095 µm or less.

In addition, a root mean square roughness (Rq) measured according to JIS B 0601 (2013) is, for example, 0.125 µm or less, and preferably 0.120 µm or less.

Both of Ra and Rq are criteria indicating the roughness of the surface shape, and a smaller value indicates less unevenness (smoothness).

The value can be measured using, for example, a known laser microscope. Details are measured by the method described in examples described below.

Copper to be treated with the etchant of the present embodiment is not particularly limited, and is particularly suitable for use in removal of a seed layer in formation of a copper wiring by a semi-additive method.

In this case, a seed layer is formed on an insulating substrate by electroless copper plating, which is a copper layer, a plating resist is formed on the seed layer, and then, pattern plating is performed on a resist opening formed on the seed layer by electrolytic copper plating. Thereafter, the plating resist is removed to form a wiring, and the seed layer remaining between the wirings is removed by wet etching with the etchant of the present embodiment, such that the wiring can be formed.

In addition, in such wiring formation, it is possible to maintain a suitable wiring shape in which the copper surface of the wiring is smooth and the amount of gouging (side etching) of the wiring is small.

By maintaining the smoothness of the copper surface of the wiring or the like in this manner, there is an advantage that a transmission loss of an electric signal can be reduced.

In addition, the etchant of the present embodiment has etching performance suitable for seed layer removal. For example, since an etching rate for the copper layer by electroless copper plating is higher than an etching rate for the copper layer by electrolytic copper plating, the seed layer removability is high, and at the same time, the side etching or the like for the wiring is small, which is suitable for seed layer removal in the wiring forming step.

In addition, the etchant of the present embodiment can suppress a decrease in smoothness of the treated copper surface even when the etching treatment is continuously performed. Therefore, a stable and highly smooth copper surface can be obtained.

In etching to remove a seed layer in formation of a copper wiring by a general semi-additive method, it is known that a chlorine ion contained in copper plating of a wiring or a seed layer is mixed in an etchant, such that a chlorine ion concentration in the etchant increases as the number of treatments increases. In a sulfuric acid hydrogen peroxide-based etchant, when a chlorine ion is contained in the etchant in an appropriate concentration range, etching is moderately suppressed, and an appropriate etching rate is maintained, however, when the concentration is excessively increased, etchability is extremely lowered, and copper cannot be sufficiently removed, or smoothness after etching may be deteriorated.

The etchant of the present embodiment can suppress a decrease in etching performance even when the chlorine ion concentration increases, and can stably obtain a copper surface having high smoothness.

Therefore, it is possible to stably obtain a copper surface having high smoothness even when a large number of objects to be treated such as substrates are continuously treated.

The etchant according to the present embodiment is as described above, but it should be considered that the embodiment disclosed herein is an example in all respects and is not restrictive. The scope of the present invention is indicated not by the above description but by the claims, and it is intended that meanings equivalent to the claims and all modifications within the scope are included.

### Examples

Hereinafter, the present invention will be described more specifically with reference to examples, but the present invention is not limited to these examples.

### [Test 1: Smoothness test]

### (Etchant)

Each etchant used in the present example was prepared.

Each etchant is an aqueous solution obtained by dissolving the following materials in ion-exchanged water as a solvent so as to have the concentration of each component described in Tables 1 to 3. Note that, although the mass of each component is also shown in Tables 1 to 3, ion-exchanged water was added in addition to the components in the tables to adjust the total amount to be 1,000 g. Furthermore, according to an adjustment method described below, 100 g of hydrogen peroxide was added in addition to the components shown in Tables 1 to 3 to finally adjust the etchant to be 1,100 g.

### (Materials)

Sulfuric acid: purified sulfuric acid, manufactured by Nissan Chemical Industries, Ltd.
Copper sulfate: manufactured by Meltex Inc.
Triazoles
   3,5-Diamino-1,2,4-triazole: manufactured by Tokyo Chemical Industry **Co.,** Ltd.
   1,2,4-Triazole: manufactured by FUJIFILM Wako Pure Chemical Corporation
   3-Amino-5-mercapto-1,2,4-triazole: manufactured by Tokyo Chemical Industry **Co.,** Ltd.
   3-Mercapto-1,2,4-triazole: manufactured by Otsuka Chemical **Co.,** Ltd.
   3-Amino-1H-1,2,4-triazole: manufactured by FUJIFILM Wako Pure Chemical Corporation
   4-Amino-3-mercapto-4H-1,2,4-triazole: manufactured by FUJIFILM Wako Pure Chemical Corporation
   3-Amino-5-methylthio-1H-1,2,4-triazole: manufactured by Tokyo Chemical Industry Co., Ltd.
   3,5-Dimethyl-1,2,4-triazole: manufactured by Tokyo Chemical Industry Co., Ltd.
Azole
   5-Aminotetrazole: manufactured by Tokyo Chemical Industry Co., Ltd.
   Benzotriazole: manufactured by Kishida Chemical Co., Ltd.
Aromatic compound
   2-Hydroxybenzoic acid (salicylic acid): manufactured by FUJIFILM Wako Pure Chemical Corporation
   Phenol: manufactured by FUJIFILM Wako Pure Chemical Corporation
   Benzoic acid: manufactured by Tokyo Chemical Industry Co., Ltd.
   5-Sulfosalicylic acid dihydrate: manufactured by Tokyo Chemical Industry Co., Ltd.
   Methyl salicylate: manufactured by FUJIFILM Wako Pure Chemical Corporation
   Acetylsalicylic acid: manufactured by FUJIFILM Wako Pure Chemical Corporation
Amino acid
   β-Alanine: manufactured by FUJIFILM Wako Pure Chemical Corporation
Hydrogen peroxide: manufactured by ADEKA Corporation

In a method for adjusting the etchant, sulfuric acid, an aromatic compound, or an amino acid is mixed with ion-exchanged water (DI water), triazoles or an azole are mixed and sufficiently dissolved, and copper sulfate as a copper ion source is mixed. Hydrogen peroxide is mixed immediately before etching.

### (Test substrate)

Substrates 1 and 2 for the following tests were prepared.

Substrate 1: A substrate obtained by forming a plating layer (20 µm) on a copper-clad laminate (CCL) having a thickness of 0.2 mm and a size of 340 × 510 mm using an electrolytic copper plating solution was cut into 100 × 100 mm.

Substrate 2: An insulating resin (25 µm) was laminated on a wafer having a thickness of 725 µm and a diameter of 200 mm, a seed layer (0.4 µm) was formed on an insulating resin using an electroless copper plating solution, and a substrate obtained by forming a pattern layer having a thickness of 6 µm and L/S = 10/10 µm on the seed layer using an electrolytic copper plating solution was cut into 10 × 10 mm.

### (Test method)

The substrate 1 was etched using each etchant.

The treatment conditions are as follows.

Each etchant at a temperature of 25°C was sprayed onto a substrate at a spray pressure of 0.1 MPa using a sprayer, and etching was performed with an etching time adjusted so that an etching amount of copper was 1.0 µm. Next, water washing was performed and drying was performed.

### (Evaluation method)

A test substrate after etching was evaluated by the following method.

### (1) Measurement of developed area ratio (Sdr) value of interface

A developed area ratio (Sdr) of an interface was measured by a confocal microscope. The Sdr value was measured by a confocal microscope (OPTELICS HYBRID+, manufactured by Lasertec Corporation) using an objective lens at a magnification of 50 times.

### (2) Method for measuring arithmetic mean roughness (Ra) and root mean square roughness (Rq)

The arithmetic mean roughness (Ra) and the root mean square roughness (Rq) were measured by a confocal microscope. The measurement was performed by a confocal microscope (apparatus used: OPTELICS HYBRID+, manufactured by Lasertec Corporation) using an objective lens at a magnification of 50 times. The arithmetic mean roughness and the root mean square roughness were measured in accordance with the standard (JIS B 0633:2001).

The results are shown in Tables 1 to 3.

**[Table 1]**

| | | **Total amount (9)** | **Azole/Triazole** | | | **Aromatic compound/Amino acid** | | | **Sulfuric acid (g)** | | **Cl ion amount** | | **Copper sulfate** | | **E.S. (µm/min)** | **Smoothness** | | |
|---|---|---|---|---|---|---|---|---|---|---|---|---|---|---|---|---|---|---|
| | | | | **g** | **wt%** | | **g** | **wt%** | **g** | **wt%** | **g** | **wt%** | **g** | **wt%** | | **Ra** | **Rq** | **Sdr** |
| **Comparative Example** | **1** | | | | | | | | | | | | | | | **0.097** | **0.116** | **0.012** |
| **Comparative Example** | **2** | **1000** | **5-Aminotetrazole** | **1.100** | **0.1000** | **β-Alanine** | **16.7** | **1.5182** | **17.6** | **1.6000** | **-** | **-** | **0** | **0.0000** | **0.23** | **0.107** | **0.128** | **0.222** |
| **Comparative Example** | **3** | **1000** | **Benzotriazole** | **1.000** | **0.0909** | **None** | **0** | **0.0000** | **192** | **17.4545** | **0.0005** | **0.00004** | **97.2** | **8.8364** | **7.62** | **0.111** | **0.135** | **0.456** |
| **Example** | **1** | **1000** | **3,5-Diamino-1,2,4-triazole** | **1.000** | **0.0909** | **Benzoic acid** | **0.5** | **0.0455** | **192** | **17.4545** | **0.0005** | **0.00004** | **97.2** | **8.8364** | **1.38** | **0.091** | **0.110** | **0.052** |
| **Example** | **2** | **1000** | | **1.000** | **0.0909** | **5-Sulfosalicylic acid dihydrate** | **0.5** | **0.0455** | **192** | **17.4545** | **0.0005** | **0.00004** | **97.2** | **8.8364** | **1.03** | **0.071** | **0.085** | **0.042** |
| **Example** | **3** | **1000** | | **1.000** | **0.0909** | **Methyl salicylate** | **0.5** | **0.0455** | **192** | **17.4545** | **0.0005** | **0.00004** | **97.2** | **8.8364** | **1.16** | **0.082** | **0.098** | **0.042** |
| **Example** | **4** | **1000** | | **1.000** | **0.0909** | **Acetylsalicylic acid** | **0.5** | **0.0455** | **1112** | **17.4545** | **0.0005** | **0.00004** | **97.2** | **8.8364** | **1.08** | **0.091** | **0.110** | **0.048** |
| **Example** | **5** | **1000** | **1,2,4-Triazole** | **1.000** | **0.0909** | **Benzoic acid** | **0.5** | **0.0455** | **192** | **17.4545** | **0.0005** | **0.00004** | **97.2** | **8.8364** | **0.80** | **0.084** | **0.102** | **0.166** |
| **Example** | **6** | **1000** | **3-Amino-5-mercapto-1,2,4-triazole** | **1.000** | **0.0909** | **Benzoic acid** | **0.5** | **0.0455** | **192** | **17.4545** | **0.0005** | **0.00004** | **97.2** | **8.8364** | **2.58** | **0.081** | **0.097** | **0.091** |
| **Example** | **7** | **1000** | **3-Mercapto-1,2,4⁻triazole** | **1.000** | **0.0909** | | **0.5** | **0.0455** | **192** | **17.4545** | **0.0005** | **0.00004** | **97.2** | **8.8364** | **1.07** | **0.076** | **0.091** | **0.059** |
| **Example** | **8** | **1000** | **None** | **0.000** | **0.0000** | **Phenol** | **0.5** | **0.0455** | **192** | **17.4545** | **0.0005** | **0.00004** | **97.2** | **8.8364** | **2.99** | **0.083** | **0.100** | **0.131** |
| **Example** | **9** | **1000** | | **0.000** | **0.0000** | **5-Sulfosalicylic acid dihydrate** | **0.5** | **0.0455** | **192** | **17.4545** | **0.0005** | **0.00004** | **97.2** | **8.8364** | **3.87** | **0.082** | **0.099** | **0.141** |
| **Example** | **10** | **1000** | | **0.000** | **0.0000** | **Methyl salicylate** | **0.5** | **0.0455** | **192** | **17.4545** | **0.0005** | **0.00004** | **97.2** | **8.8364** | **3.97** | **0.081** | **0.098** | **0.110** |
| **Example** | **11** | **1000** | | **0.000** | **0.0000** | **Acetylsalicylic acid** | **0.5** | **0.0455** | **192** | **17.4545** | **0.0005** | **0.00004** | **97.2** | **8.8364** | **3.24** | **0.084** | **0.101** | **0.112** |

**[Table 2]**

| | | **Total amount (g)** | **Azole/Triazele** | | | **Aromatic compound/Amino acid** | | | **Sulfuric acid (g)** | | **Cl ion amount** | | **Copper sulfate** | | **E.S (µm/min)** | **Smoothness** | | |
|---|---|---|---|---|---|---|---|---|---|---|---|---|---|---|---|---|---|---|
| | | | | **g** | **wt%** | | **g** | **wt%** | **g** | **wt%** | **g** | **wt%** | **g** | **wt%** | | **Ra** | **Rq** | **Sdr** |
| **Comparative Example** | **4** | **1000** | **1,2,4-Triazole** | **1.000** | **0.0909** | **None** | **0** | **0.0000** | **192** | **17.4545** | **0.0005** | **0.00004** | **97.2** | **8.8364** | **0.84** | **0.100** | **0.126** | **0.211** |
| **Example** | **12** | **1000** | **None** | **0.000** | **0.0000** | **Benzoic acid** | **0.5** | **0.0455** | **192** | **17.4545** | **0.0005** | **0.00004** | **97.2** | **8.8364** | **3.53** | **0.074** | **0.090** | **0.093** |
| **Example** | **13** | **1000** | **3,5-Diamino-1,2,4-triazole** | **0.001** | **0.0001** | | **0.5** | **0.0455** | **192** | **17.4545** | **0.0005** | **0.00004** | **97.2** | **8.8364** | **2.67** | **0.092** | **0.111** | **0.132** |
| **Example** | **14** | **1000** | | **0.010** | **0.0009** | | **0.5** | **0.0455** | **192** | **17.4545** | **0.0005** | **0.00004** | **97.2** | **8.8364** | **2.18** | **0.084** | **0.103** | **0.127** |
| **Example** | **15** | **1000** | | **0.100** | **0.0091** | | **0.5** | **0.0455** | **192** | **17.4545** | **0.0005** | **0.00004** | **97.2** | **8.8364** | **1.93** | **0.092** | **0.119** | **0.120** |
| **Example** | **16** | **1000** | | **5.000** | **0.4545** | | **0.5** | **0.0455** | **192** | **17.4545** | **0.0005** | **0.00004** | **97.2** | **8.8364** | **0.77** | **0.087** | **0.104** | **0.040** |
| **Example** | **17** | **1000** | **None** | **0.000** | **0.0000** | | **0.01** | **0.0009** | **192** | **17.4545** | **0.0005** | **0.00004** | **97.2** | **8.8364** | **2.86** | **0.093** | **0.113** | **0.174** |
| **Example** | **18** | **1000** | | **0.000** | **0.0000** | | **0.1** | **0.0091** | **192** | **17.4545** | **0.0005** | **0.00004** | **97.2** | **8.8364** | **3.10** | **0.085** | **0.102** | **0.150** |
| **Example** | **19** | **1000** | | **0.000** | **0.0000** | | **2.0** | **0.1818** | **192** | **17.4545** | **0.0005** | **0.00004** | **97.2** | **8.8364** | **2.51** | **0.088** | **0.106** | **0.114** |

**[Table 3]**

| | | **Total amount (g)** | **Azole/Triazole** | | | **Aromatic compound/Amino acid** | | | **Sulfuric acid (g)** | | **Cl ion amount** | | **Copper sulfate** | | **E.S. (µm/min)** | **Smoothness** | | |
|---|---|---|---|---|---|---|---|---|---|---|---|---|---|---|---|---|---|---|
| | | | | **g** | **wt%** | | **g** | **wt%** | **g** | **wt%** | **g** | **wt%** | **g** | **wt%** | | **Ra** | **Rq** | **Sdr** |
| **Example** | **20** | **1000** | **3-Amino-1H-1,2,4-triazole** | **1.000** | **0.0909** | **Benzoic acid** | **0.5** | **0.0455** | **192** | **17.4545** | **0.0005** | **0.00004** | **97.2** | **8.8364** | **1.29** | **0.070** | **0.085** | **0.034** |
| **Example** | **21** | **1000** | **3,5-Diamino-1,2,4-triazole** | **1.000** | **0.0909** | **Salicylic acid** | **0.5** | **0.0455** | **192** | **17.4545** | **0.0005** | **0.00004** | **97.2** | **8.8364** | **1.34** | **0.073** | **0.087** | **0.073** |
| **Example** | **22** | **1000** | **3-Amino-1H-1,2,4-triazole** | **1.000** | **0.0909** | **Methyl salicylate** | **0.5** | **0.0455** | **192** | **17.4545** | **0.0005** | **0.00004** | **97.2** | **8.8364** | **1.85** | **0.079** | **0.097** | **0.151** |
| **Example** | **23** | **1000** | | | **0.0909** | **Acetylsalicylic acid** | **0.5** | **0.0455** | **192** | **17.4545** | **0.0005** | **0.00004** | **97.2** | **8.8364** | **0.97** | **0.070** | **0.085** | **0.075** |
| **Example** | **24** | **1000** | **3-Amino-5-mercapto-1,2,4-triazole** | **1.000** | **0.0909** | **Salicylic acid** | **0.5** | **0.0455** | **192** | **17.4545** | **0.0005** | **0.00004** | **97.2** | **8.8364** | **0.87** | **0.075** | **0.091** | **0.115** |
| **Example** | **25** | **1000** | **3-Mercapto-1,2,4-triazole** | **1.000** | **0.0909** | | | **0.0455** | **192** | **17.4545** | **0.0005** | **0.00004** | **97.2** | **8.8364** | **1.43** | **0.069** | **0.084** | **0.097** |
| **Example** | **26** | **1000** | **4-Amino-3-mercapto-4H-1.2.4-triazole** | **1.000** | **0.0909** | | | **0.0455** | **192** | **17.4545** | **0.0005** | **0.00004** | **97.2** | **8.8364** | **1.96** | **0.075** | **0.091** | **0.119** |
| **Example** | **27** | **1000** | **3-Amino-5-methylthio-1H-1.2,4-triazole** | **1.000** | **0.0909** | | | **0.0455** | **192** | **17.4545** | **0.0005** | **0.00004** | **97.2** | **8.8364** | **2.09** | **0.089** | **0.108** | **0.077** |
| **Example** | **28** | **1000** | **3,5-Dimethyl-1,2,4-triazole** | **1.000** | **0.0909** | | | **0.0455** | **192** | **17.4545** | **0.0005** | **0.00004** | **97.2** | **8.8364** | **1.94** | **0.079** | **0.096** | **0.122** |

As shown in Tables 1 to 3, in each example, the Sdr value was in the range of 0.20% or less, the Ra was in the range of 0.11 µm or less, the Rq was in the range of 0.125 µm, and the smoothness was more excellent than that of the comparative example subjected to the etching treatment (Comparative Example 1 is an untreated control).

### [Test 2: Evaluation of residual property of Cu]

Using the etchants of Examples 1 and 8 (with 100 g of hydrogen peroxide added as a component in the table) and the substrate 2 in the above examples, the treatment time was adjusted so that the etching amount of copper in the pattern layer of the substrate 2 was 0.5 µm, and the treatment was performed to examine the residual property of copper after etching.

For the evaluation, three points on the surface of the resin portion between the patterns of the test substrate after etching were arbitrarily selected, and the surface was analyzed by an Energy dispersive X-ray spectrometry (EDS) apparatus. The apparatus used was JSM-IT200A (manufactured by JEOL Ltd.), and analysis was performed at an acceleration voltage of 10 kv.

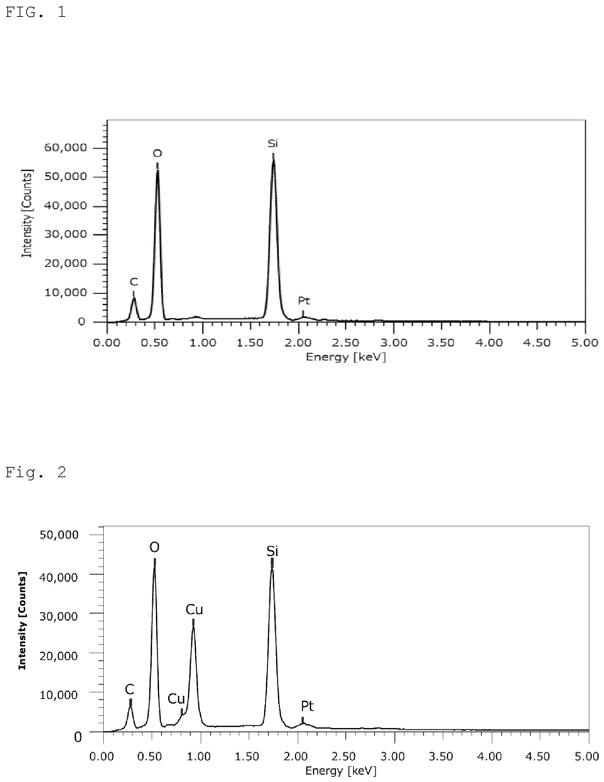

The measured results of one point among the three points are shown in Figs. 1 and 2.

Fig. 1 shows the result of etching with the etchant of Example 1 containing triazole, and peaks were observed between the patterns at positions indicating the presence of C, Si, and O derived from the insulating resin, but no peak appeared at a position indicating the presence of Cu.

On the other hand, Fig. 2 shows the result of etching with the etchant of Example 8 containing no triazole, and peaks were observed between the patterns at positions indicating the presence of C, Si, and O derived from the insulating resin, and a peak was also observed at a position indicating the presence of Cu. Note that similar results were obtained in the other two points.

Therefore, it was found that the test substrate treated with the etchant of the example containing triazole had excellent smoothness, and at the same time, the residual property of the seed layer copper was low.

### [Test 3: Influence of chlorine ion concentration]

An etchant adjusted using DI water as a solvent so as to have the concentration of each component described in Table 4 was prepared.

Assuming that the chlorine ion is dissolved in the etchant by etching the copper-plated substrate for a long period of time, the substrate 1 was etched with 14 types of etchants, each of which had a chlorine ion concentration varying from 0.25 mg/L to 100 mg/L by based on the etchant. Etching conditions are the same as in Test 1. Note that, in the same manner as in Test 1, 100 g of hydrogen peroxide was added to the components in the table to prepare an etchant.

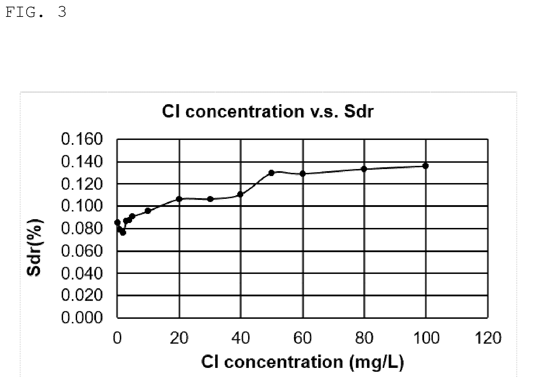

The results of measuring the Sdr value after etching by the same method as in Test 1 are shown in Table 5 and Fig. 3.

Note that an etching rate was calculated by measuring the weight of the substrate before and after etching, and dividing the weight by the area of the substrate and the etching time as µm/min.

This is also shown in Table 5.

**[Table 4]**

| Total amount (g) | Azole | | Aromatic compound | | Sulfuric acid (g) | Copper sulfate (g) |
|---|---|---|---|---|---|---|
| | Substance name | Addition amount | Substance name | Addition amount | | |
| 1000 | 3,5-Diamino-1,2,4-triazole | 1.0 | Benzoic acid | 0.5 | 192 | 97.2 |

**[Table 5]**

| **Cl concentration (mg/L)** | **E.S. (µm/min)** | **Sdr** |
|---|---|---|
| **0.25** | 1.71 | 0.085 |
| **1** | 1.22 | 0.079 |
| **2** | 1.18 | 0.076 |
| **3** | 1.16 | 0.086 |
| **4** | 1.14 | 0.087 |
| **5** | 1.14 | 0.090 |
| **10** | 1.10 | 0.095 |
| **20** | 1.04 | 0.106 |
| **30** | 1.04 | 0.106 |
| **40** | 1.01 | 0.110 |
| **50** | 0.97 | 0.130 |
| **60** | 0.95 | 0.129 |
| **80** | 0.95 | 0.133 |
| **100** | 0.92 | 0.135 |

As shown in the graphs of Table 5 and Fig. 3, the Sdr value also increased as the chlorine ion concentration increased, but the Sdr value was 0.2 or less even when the chlorine ion concentration was increased to 100 mg/L. In addition, the etching rate was also relatively stable.

## Claims

1. A copper etchant comprising hydrogen peroxide, sulfuric acid, an aromatic compound, and a chlorine ion,
wherein the aromatic compound has a structure in which a hydroxyl group and/or a carboxy group is bonded to a benzene ring.

2. The copper etchant according to claim 1, wherein the chlorine ion is contained in an amount of 0.000020 mass% or more and 0.02 mass% or less.

3. The copper etchant according to claim 1, wherein the aromatic compound is one or more selected from the group consisting of phenols, a benzoic acid compound, 2-hydroxybenzoic acid, 5-sulfosalicylic acid, methyl salicylate, sodium salicylate, isoamyl salicylate, and acetylsalicylic acid.

4. The copper etchant according to claim 1, further comprising triazoles.

5. The copper etchant according to claim 4, wherein the triazoles are one or more selected from the group consisting of 1,2,4-triazole, 1,2,3-triazole, 3-amino-5-mercapto-1,2,4-triazole, 3,5-diamino-1,2,4-triazole, 3,5-dimethyl-1,2,4-triazole, 3-mercapto-1,2,4-triazole, 4-amino-1,2,4-triazole, 3-amino-1,2,4-triazole, 4-amino-3-mercapto-4H-1,2,4-triazole, and 3-amino-5-methylthio-1H-1,2,4-triazole.
